Europäisches Patentamt

European Patent Office

Office européen des brevets

(19)

(11) Publication number: **0 130 410**
**A2**

# (12) EUROPEAN PATENT APPLICATION

(21) Application number: **84106495.9**

(22) Date of filing: **06.06.84**

(51) Int. Cl.⁴: **H 05 K 1/02,** H 05 K 1/18, H 03 H 9/10

(30) Priority: **07.06.83 JP 86434/83 U**

(43) Date of publication of application: **09.01.85 Bulletin 85/2**

(84) Designated Contracting States: **DE FR GB**

(71) Applicant: **NEC CORPORATION, 33-1, Shiba 5-chome, Minato-ku, Tokyo 108 (JP)**

(72) Inventor: **Umetsu, Shinjiro, c/o NEC Corporation 33-1, Shiba 5-chome, Minato-ku Tokyo (JP)**
Inventor: **Yoshizawa, Shigeo, c/o NEC Corporation 33-1, Shiba 5-chome, Minato-ku Tokyo (JP)**

(74) Representative: **Vossius Vossius Tauchner Heunemann Rauh, Siebertstrasse 4 P.O. Box 86 07 67, D-8000 München 86 (DE)**

(54) Printed circuit board structure for metal package containing high-frequency component.

(57) The printed circuit board structure mounts a metal package with a circuit component for use in a high-frequency region contained therein. The structure comprises a grounding hole bored partially in an area of the printed circuit board under the metal package and means for connecting the metal package with conductors on the printed circuit board via the grounding hole.

This printed circuit board structure improves the characteristics of the high-frequency components contained in the metal package and minimizes the mounting area for a metal package.

VOSSIUS · VOSSIUS · TAUCHNER · HEUNEMANN · RAUH

PATENTANWÄLTE

EUROPEAN PATENT ATTORNEYS

0130410

Our Ref.: T 113 EP
Case:      86434/83
NEC Corporation,
Tokyo, Japan

June 6, 1984

Printed Circuit Board Structure for

Metal Package Containing High-Frequency Component

This invention relates to a printed circuit board structure and, more particularly, to a printed circuit board structure suitable for mounting a package containing high-frequency components, such as surface accoustic wave (SAW) devices.

These components are usually hermetically sealed in a metal package to increase the reliability. The metal package containing an SAW device as a filter, or a resonator, for example, must be high-frequency grounded in order to gain a desired high-frequency characteristic.

In a prior art grounding structure, the metal package is pressed upon conductive patterns on a printed circuit board with a conductive spring plate. This structure, however, is not desirable because it requires a large space and the characteristics of a high-frequency component will deteriorate by contact resistances between the metal package and the conductive patterns and between the metal package and the spring plate. In another prior art structure, a package and conductive patterns are soldered at several points. But this structure causes difficulties in replacing and mounting works and further, the space required for soldering becomes a dead space. In a still another conventional structure, lead wires are soldered to through-holes of a printed board while a package is being pressed on conductive patterns. Working is slightly improved in this case, but the problem about high-frequency characteristics remains because there is still a possibility for insufficient contact.

Summary of the Invention:

It is therefore an object of the present invention to provide a printed circuit board structure for high-frequency components which is capable of improving characteristics of the high-frequency components contained in a metal package.

Another object of the present invention is to provide a printed circuit board structure wherein the mounting area for a metal package which contains high-frequency components can be minimized.

Still another object of the present invention is to provide a printed circuit board structure having improved performance for mounting and replacement of a metal package which houses high-frequency components.

Still further object of the present invention is to provide a printed circuit board structure which is suitable for a metal package containing a band-pass filter (BPF) including an SAW device.

According to the present invention, there is provided a printed circuit board structure mounting a metal package with a circuit component for use in a high-frequency region contained therein, the structure comprising: a grounding hole bored partially in an area of the printed circuit board under the metal package; and means for connecting the metal package with conductors on the printed circuit board via the grounding hole.

Brief Description of the Drawings:

The above and other features and advantages of the present invention will become more apparent from the description given hereinbelow referring to the accompanying drawings, in which:

Fig. 1 is a schematic circuit diagram of a high-frequency amplifier whose output is connected to a band-pass filter including an SAW devices;

Fig. 2 is a perspective view for explaining the principle of a filter employing an SAW device;

Fig. 3 is a partially exploded perspective view of a metal package hermetically housing the filter of the SAW device shown in Fig. 2;

Fig. 4 is a bottom view of the printed circuit board structure according to the present invention;

Fig. 5 is an enlarged cross section taken along the line A-O-B of Fig. 4;

Figs. 6A and 6B show another embodiment of the present invention, indicating respectively the printed circuit board viewed from the bottom and from the top side thereof;

Fig. 7 is a graph showing frequency characteristic exhibited when a BPF is mounted on the printed circuit board having no through-hole for grounding, which is referred to as "grounding hole" hereinafter; and

Fig. 8 is a graph showing frequency characteristics exhibited when a BPF is mounted on a printed circuit board having a grounding hole according to the present invention.

Detailed Description of the Preferred Embodiment:

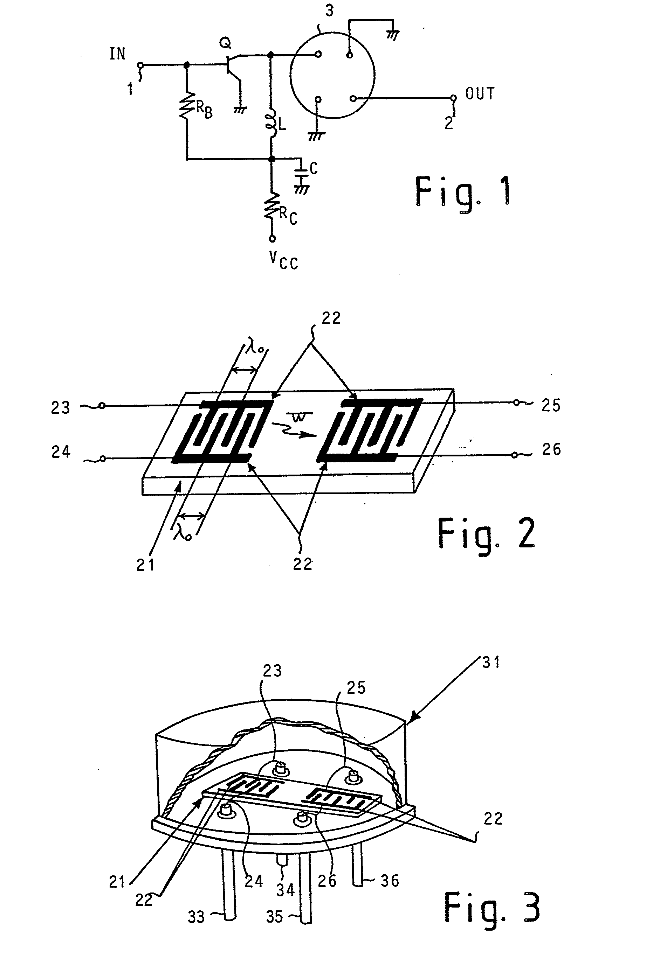

In Fig. 1, a signal IN applied to an input terminal 1 is amplified by a transistor Q, removed of undesired wave components by a band-pass filter (BPF) 3, and outputed from an output terminal 2 as an output signal OUT. Resistors $R_B$ and $R_C$ are to apply a DC bias from a DC power source $V_{cc}$ to the transistor Q. A coil L is a high-frequency choke coil and a capacitor C is for high-frequency by-pass. The BPF 3 includes an SAW device.

In Fig. 2, the SAW device filter comprises comb-like electrodes 22 formed on a piezoelectric substrate 21 of $L_iT_aO_3$ or $L_iN_bO_3$. The comb-like electrodes 22 are connected to input terminals 23, 24 and output terminals 25, 26. When an electromagnetic wave is applied to the input terminals 23 and 24, a surface wave W is generated by piezoelectric effect and is transmitted to the output terminals 25 and 26. The transfer characteristic of the surface wave W is determined by spatial interval $\lambda_0$ between comb-like electrodes 22, the number of pairs or the shape of the electrodes 22, so that SAW device filters having various frequency characteristics can be achieved.

In Fig. 3, the filter shown in Fig. 2 is hermetically sealed in a metal package 31 of TO-5, for example. The input/output terminals 23, 24 and 25, 26 are respectively connected to lead wires 33, 34 and 35, 36. The figure schematically shows the state of the SAW device 21 in the package 31. In actual dimension for 450 MHz band, the package 31 is 9.1 mm in diameter, and 4.0 mm in height; the interval between lead wires 33 and 34, 33 and 35, and 35 and 36 is 3.6 mm; and the substrate 21 is 4.0 mm in length and 3.0 mm in width.

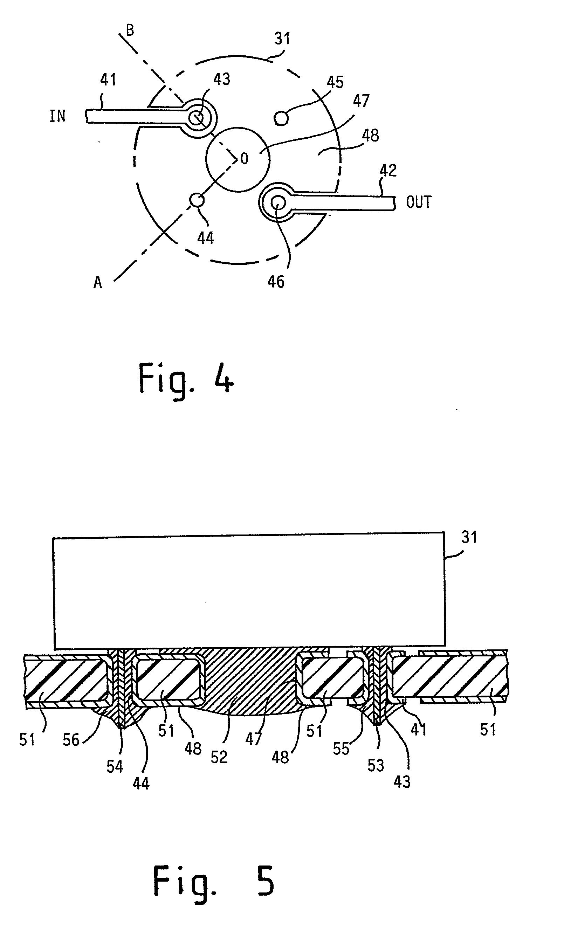

In Fig. 4, the input/output conductive patterns 41, 42 are respectively connected to through-holes 43, 46. Other through-holes 44, 45 and a grounding hole 47, which is a feature of this invention, are connected to a ground conductive pattern 48. The grounding hole 47 bored in an area of a printed circuit board 51 (See Fig. 5) on which the BPF package 31 is mounted, as marked with a phantom line (one-dot chain). The BPF package is positioned on the side opposing to the conductive patterns 41, 42, and 48 on the printed circuit board 51.

- 6 -　　　　　　　0130410

In Fig. 5, the bottom surface of the BPF package 31 and the ground pattern 48 of the printed circuit board 51 are soldered or brazed (52) through the grounding hole 47. Lead wires 53, 54 from the package 31 are respectively inserted into corresponding through-holes 43, 44 and soldered (55, 56). Since the diameter of the grounding hole 47 is made sufficiently larger than that of the through-holes 43 through 46, undesired capacitance or inductance between the package 31 and the ground pattern 48 can be minimized. This contributes to greatly improving the frequency characteristic of the BPF, which will be explained later in more detail.

Since the area required for mounting the package 31 on the printed circuit board 51 is limited to the bottom surface of the package, the mounting area becomes conveniently smaller than those needed for mounting with a spring plate or mounting by soldering on periphery of the package. The package 31 can be mounted on the printed circuit board 51 simply by inserting lead wires respectively into through-holes and soldering them with automatic soldering or flow soldering. The performance for mounting and replacement of the package can, therefore, be greatly improved.

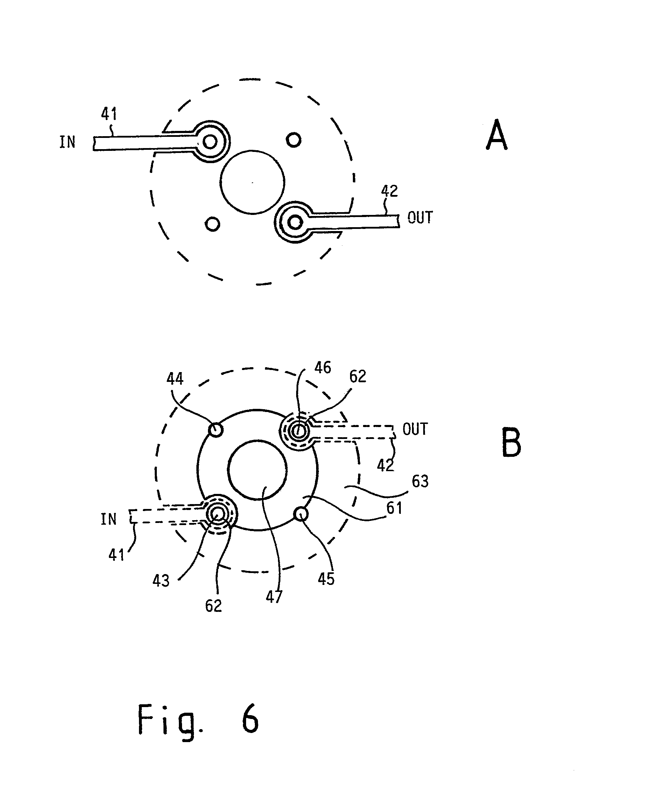

In Fig. 6A, the pattern viewed from the bottom side of a printed circuit board is identical with the embodiment shown in Fig. 4. On the other hand, as shown in Fig. 6B, on the side where components are mounted and around the through-holes 43, 46, there is provided an area from which conductive patterns are removed.  Around the grounding hole 47 further is provided an area 61 from which resist alone is removed.  The rest of the surface 63 is covered with resist.  As mentioned above, by applying resist suitably on the surface, the solder which might flow from the grounding hole 47 can be limited within the area 61 where no resist is applied.  This can prevent the input/output lead wires from being grounded erroneously.  The replacement of the package can further be facilitated.

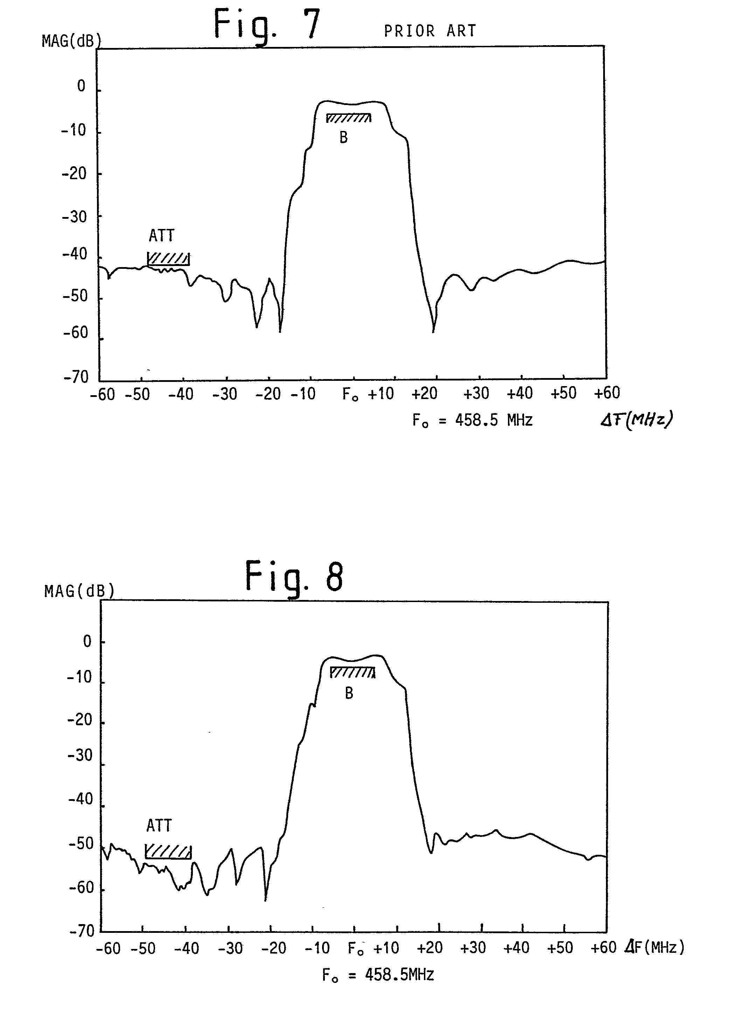

The frequency characteristics of BPF shown in Fig. 7 are obtained when a package is mounted on a printed circuit board by soldering a TO-5 type metal package containing an SAW device to lead wires while pressing the same.  This BPF is designed to have a center frequency $F_0$ at 458.5 MHz and 6 dB band-width B of 10 MHz  attenuate signals in a frequency band ATT (image frequency) which is tuned apart from the in-band frequency by 42.8 MHz to the negative side. The size of the package is the same as the one described in reference to Fig. 3.

In Fig. 8, the frequency characteristics of BPF are obtained when a printed circuit board structure shown in Figs. 4 and 5 is used but the metal package is the same as the one used for  Fig. 7.   The diameter of the grounding hole 47 is set at about 2 mm. ·The center frequency

$F_0$, 6 dB band-width B and the image frequency band-width ATT are the same as the ones shown in Fig. 7, respectively. As obvious from Figs. 7 and 8, the BPF mounted on the printed circuit board structure according to this invention is superior to the BPF of Fig. 7 by about 10 dB in out-band attenuation (ATT).

It will be readily understood that similar effect can be achieved for metal packages accommodating transistors, ICs or components or circuits other than SAW device filters.

- 9 -    0130410

CLAIMS

1.   A printed circuit board structure mounting a metal package with a circuit component for use in a high-frequency region contained therein, said structure comprising:

a grounding hole bored in an area of said printed circuit board under said metal package; and

means for connecting said metal package with conductors on said printed circuit board through said grounding hole.

2.   A printed circuit board structure as claimed in Claim 1 wherein said connecting means comprises solder.

3.   A printed circuit board structure as claimed in Claim 2 wherein said circuit component has lead wires extended from the bottom of said metal package, and wherein said printed circuit board structure includes through-holes, said lead wires passing through said through-holes,   and solder connecting said lead wires with conductors on said printed circuit board.

4.   A printed circuit board structure as claimed in Claim 3 wherein said metal package is at earth potential.

5.   A printed circuit board structure as claimed in Claim 3 or 4 wherein said grounding hole is circular.

6. A printed circuit board structure as claimed in Claim 5 wherein the diameter of said grounding hole is larger than that of said through-holes.

7. A printed circuit board structure as claimed in any of Claims 3 to 6 wherein conductive patterns of said printed circuit board on the side mounting said metal package are applied with resist except for the areas around said grounding hole.

8. A printed circuit board structure as claimed in Claim 7 wherein conductive patterns are removed from the area around said through-holes on said mounting side.

9. A printed circuit board structure as claimed in any of Claims 4 to 8 wherein said circuit component is a band-pass filter including a surface accoustic wave device.

10. A printed circuit board structure as claimed in Claim 9 wherein said band-pass filter has a frequency band-width of 400 MHz.

11. A method for mounting a metal package containing a circuit component for use in a high-frequency region on a printed circuit board, said method comprising the steps of:

boring a grounding hole in an area of said printed circuit board under said metal package; and

soldering conductors on said printed circuit board with said metal package through said grounding hole.

12.  A method as claimed in Claim 11 further comprising the steps of:

boring through-holes in said printed circuit board in order to pass lead wires for terminals of said circuit components; and

soldering said lead wires to a part of conductors of said printed circuit board.

1/4

0130410

Fig. 1

Fig. 2

Fig. 3

Fig. 4

Fig. 5

Fig. 6

4/4

0130410

Fig. 7  PRIOR ART

MAG(dB)

B

ATT

$F_o$ = 458.5 MHz

$\Delta F(MHz)$

Fig. 8

MAG(dB)

B

ATT

$F_o$ = 458.5MHz

$\Delta F(MHz)$